Europäisches Patentamt

European Patent Office

Office européen des brevets

(11) Publication number: **0 450 268 A2**

# EUROPEAN PATENT APPLICATION

(21) Application number: **91100582.5**

(22) Date of filing: **18.01.91**

(51) Int. Cl.5: **H03J 5/02**

(30) Priority: **04.04.90 JP 88171/90**

(43) Date of publication of application:
**09.10.91 Bulletin 91/41**

(84) Designated Contracting States:
**DE FR GB**

(71) Applicant: **PIONEER ELECTRONIC
CORPORATION**
**No. 4-1, Meguro 1-chome
Meguro-ku Tokyo 153(JP)**

(72) Inventor: **Kamiya, Kazuhiro, c/o Pioneer
Electronic Corp.**

Kawagoe Kojo, 25-1 Aza Nishimachi
Oaza Yamada, Kawagoe-shi, Saitama 350(JP)
Inventor: **Abe, Shinichi, c/o Pioneer
Electronic Corporation**
Kawagoe Kojo, 25-1 Aza Nishimachi
Oaza Yamada, Kawagoe-shi, Saitama 350(JP)
Inventor: **Watanabe, Shuji, c/o Pioneer
Corporation**
4-1, Meguro 1-chome
Meguro-ku, Tokyo 153(JP)

(74) Representative: **Reinhard, Skuhra, Weise**
**Friedrichstrasse 31**
**W-8000 München 40(DE)**

(54) **A radio station presetting method for radio receivers.**

(57) A method of presetting radio stations which makes it possible to rewrite the data of radio stations preset in memory to improve the usefulness and versatility of radio receivers.

A radio station presetting method according to the present invention has the steps of: dividing the frequency band into a plurality of dividing frequency bands with a seek-scanning priority order; seek-scanning the dividing frequency band having highest seek-scanning priority order to determine whether or not the number of broadcasting stations with the reception field strength higher than the specified level becomes the predetermined number; retaining the broadcasting stations which are preset with the dividing frequency band having the highest seek-scanning priority order as they are when the number of broadcasting stations is less than the predetermined number; seek-scanning the dividing frequency band having next higher seek-scanning order to determine whether or not the number of broadcasting stations with the reception field strength higher than the specified level becomes the predetermined number; retaining the broadcasting stations which are so far as they are when the number of said broadcasting stations is less than the predetermined number; and sequentially repeating the operation for said dividing frequency band of lower seek-scanning priority order.

FIG. 1

## BACKGROUND OF THE INVENTION

### 1. Field of the Invention

The present invention relates to a radio station presetting method for radio receivers, in which, by performing seek-scanning over a frequency band of the same modulation type, a predetermined number of radio stations with the reception field strength higher (stronger) than a specified level are selected in the order of reception field strength, starting with the highest reception level, and then set in memory.

### 2. Prior Art

Heretofore, when broadcasting stations are preset in radio receivers, a BSM (best station memory) function for presetting broadcasting stations having higher reception field strength or an automatic presetting function is provided.

This BSM function or the automatic presetting function is a function of seek-scanning a frequency band of the same modulation type to select a predetermined number of broadcasting stations, for example six stations, with the reception field strength higher than a predetermined level in the descending order of reception field strength and storing them in a memory.

After the data of predetermined number of broadcasting stations are stored in the memory by the BSM or the automatic presetting function, a tuning key in the operation section corresponding to the desired broadcasting station is operated to hear information from the desired broadcasting station.

In a conventional broadcasting station preset system for radio receivers, however, since the predetermined number of radio stations with their reception field strength higher than a specified level are selected by seek-scanning in the descending order of reception level and the data of these selected stations are set in the memory, a first channel and a third channel of television broadcasting are included, for example, in the frequency band of an FM broadcasting. When the reception field strength of the first and third channels are higher than that of the normal FM broadcasting stations, the first and third channels are preset even if only the normal FM broadcasting stations are desirably preset, and the number of normal FM broadcasting stations to be preset is reduced.

Under the condition, when only the normal FM broadcasting stations are desired to be preset, the number of normal FM broadcasting stations actually preset is less than the desired number of stations or even if the number of broadcasting stations having the predetermined reception field strength are less than the predetermined number, there occurs an inconvenience that the first or/and the third channels of the television broadcasting are not preset.

## SUMMARY OF THE INVENTION

The present invention has been accomplished to eliminate the above-described inconvenience and provides a radio station presetting method for radio receivers which can sequentially preset broadcasting stations in dividing frequency bands having a higher seek-scanning priority order.

A radio station presetting method for a radio receiver according to the present invention has the steps of: dividing the frequency band into a plurality of dividing frequency bands with a seek-scanning priority order; seek-scanning the dividing frequency band having highest seek-scanning priority order to determine whether or not the number of broadcasting stations with the reception field strength higher than the specified level becomes the predetermined number; retaining the broadcasting stations which are preset with the dividing frequency band having the highest seek-scanning priority order as they are when the number of broadcasting stations is less than the predetermined number; seek-scanning the dividing frequency band having next higher seek-scanning order to determine whether or not the number of broadcasting stations with the reception field strength higher than the specified level becomes the predetermined number; retaining the broadcasting stations which are so far as they are when the number of said broadcasting stations is less than the predetermined number; and sequentially repeating the operation for said dividing frequency band of lower seek-scanning priority order.

A radio station presetting method for radio receivers according to another aspect of this invention, the seek-scanning includes a high reception field strength seek-scanning for presetting broadcasting stations with the reception field strength higher than a predetermined level and a low reception field strength seek-scanning for presetting broadcasting stations with the reception field strength higher than a predetermined level which is lower than the predetermined level applied for the high reception field strength seek-scanning by a prescribed level.

A radio station presetting method for radio receivers according to still another aspect of this invention, at least one intermediate reception field strength seek-scanning is set between the high reception field strength seek-scanning for presetting broadcasting stations with the reception field strength higher than a predetermined level and the low reception field strength seek-scanning for presetting broadcasting stations with the reception field strength higher than a predetermined level which is lower than the predetermined level applied for the high reception field strength seek-scanning by a prescribed level, seek-scanning is performed from the high reception field strength seek-scanning side.

A radio station presetting method for radio receivers according to still another aspect of this invention, broadcasting stations to be preset in the descending order of the dividing frequency band having high seek-scanning priority are allocated to channels in the descending order.

A radio station presetting method for radio receivers according to still another aspect of the invention, a plurality of dividing frequency bands can be arbitrarily set.

BRIEF DESCRIPTION OF THE DRAWINGS

Fig. 1 is a block diagram showing an arrangement of a radio receiver according to an embodiment of this invention;
Fig. 2 comprising 2A and 2B is a flow chart for explaining an example of the operation;
Fig. 3 is an explanatory view showing the operation of seek-scanning;
Fig. 4 is an explanatory view showing distribution and reception field strength of broadcasting stations; and
Fig. 5 comprising 5A and 5B is a flow chart for explaining other operation.

DESCRIPTION OF THE PREFERRED EMBODIMENT

One embodiment of this invention will be described with reference to accompanying drawings.

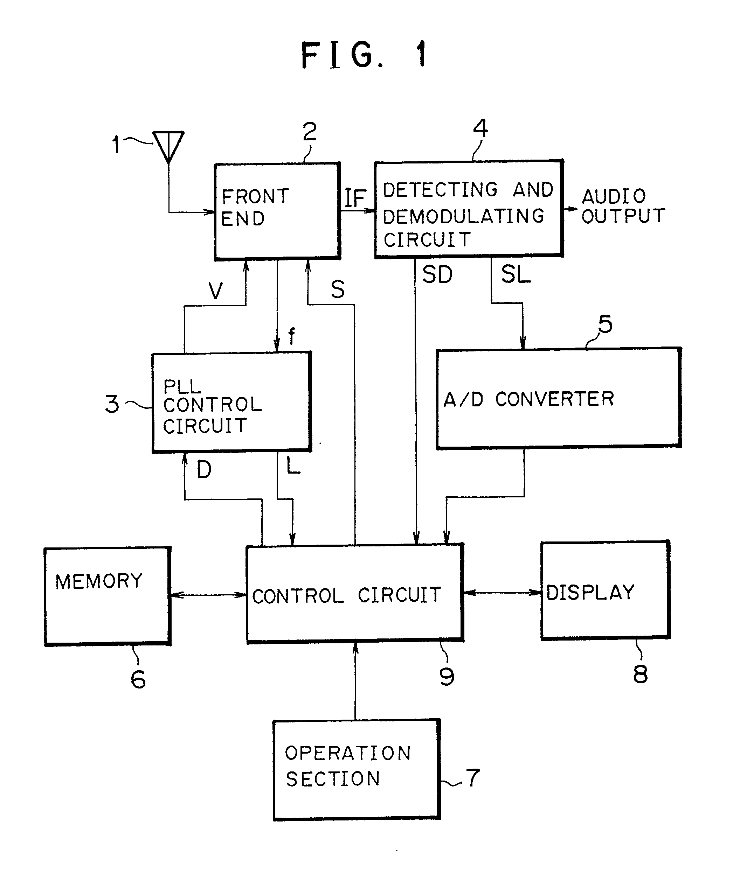

Fig. 1 is a block diagram showing the arrangement of a radio receiver according to one embodiment of this invention, and reference numeral 1 denotes an antenna for receiving a radio wave.

Reference numeral 2 denotes a front end, which determines a receiving frequency f from the antenna 1 according to a tuning voltage V output from a PLL (phase-lock loop) control circuit 3 to be described later, outputs the received frequency f to the PLL control circuit 3, converts the received frequency f higher than an input sensitivity set signal S of a control circuit 9 to be described later into an IF (intermediate frequency), and outputs it.

Reference numeral 3 denotes a PLL control circuit composed of PLL, etc., which outputs a tuning voltage V based on a frequency division data D from the control circuit 9 to the front end 2, and outputs a lock completion signal L to the control circuit 9 when the received frequency f based on the tuning voltage V is supplied from the front end 2 thereto.

Reference numeral 4 denotes a detecting and demodulating circuit which detects an IF signal from the front end 2, modulates it into an audio signal before outputting it, and at the same time outputs a station detection signal SD and a reception field strength (electric field strength) signal SL to the control circuit 9.

Reference numeral 5 denotes an analog-to-digital (A/D) converter for converting the reception field strength signal SL output from the detecting and demodulating circuit 4, which is an analog signal, to a digital signal. Numeral 6 denotes a memory, which stores various data based on the control of the control circuit 9.

The number of radio stations (channels) to be preset in the memory 6 is six.

Reference numeral 7 denotes an operation section, which has various types of keys, switches for performing a predetermined operation.

Reference numeral 8 denotes a display unit, which displays the number of preset key, received frequency, etc.

Reference numeral 9 denotes a control circuit, which controls the front end 2, the PLL control circuit 3, the memory 6 and the display unit 8 to be described later based on the outputs of the PLL control circuit 3 to the A/D converter 5, the data of the memory 6 and the output of the operation section 7.

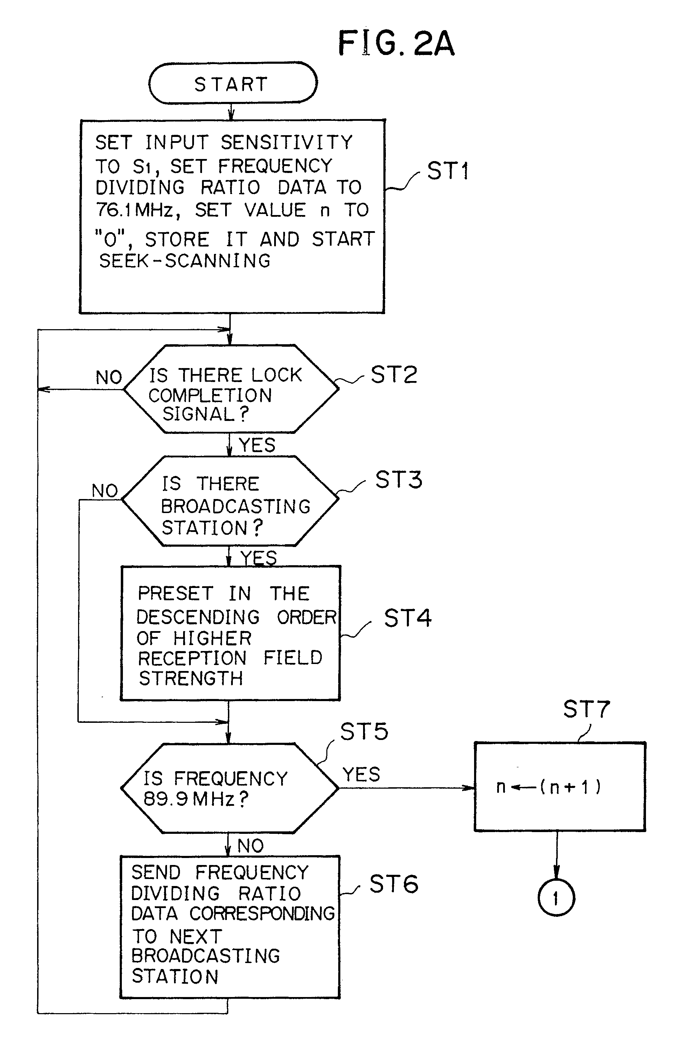

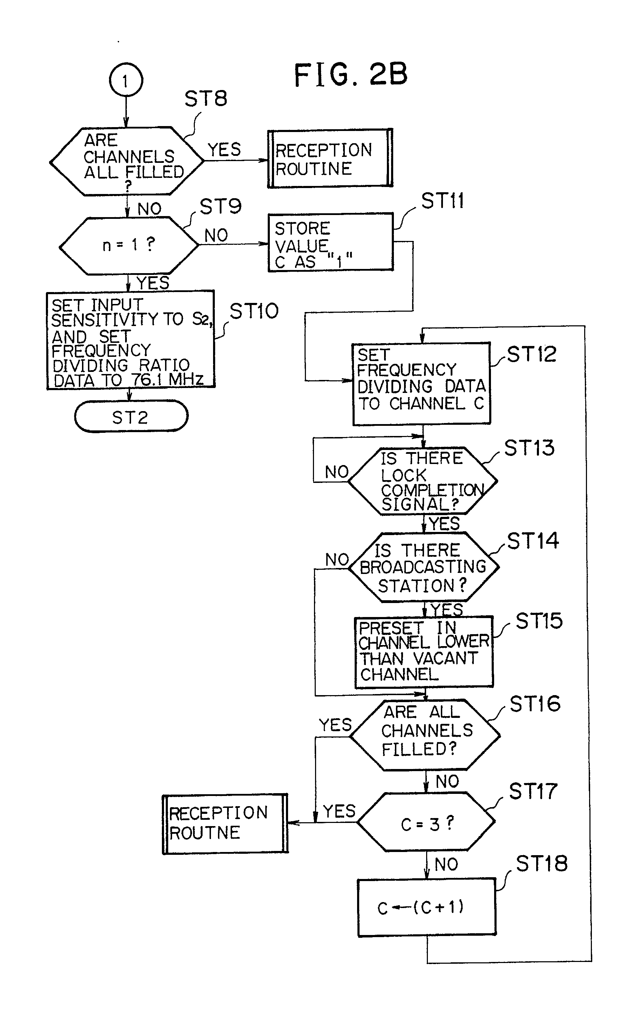

Fig. 2 comprising 2A and 2B is a flow chart for explaining an example of the operation, and ST1 to ST18 represent each step.

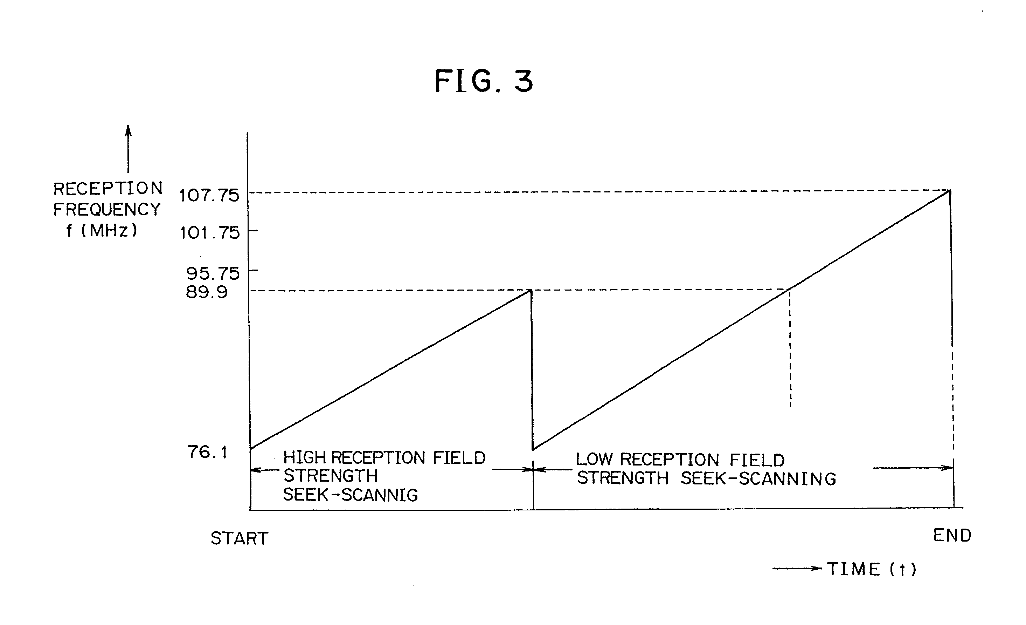

Fig. 3 is an explanatory view showing the operation of a seek-scanning, in which an abscissa axis indicates a time t, and an ordinate axis indicates a reception frequency f.

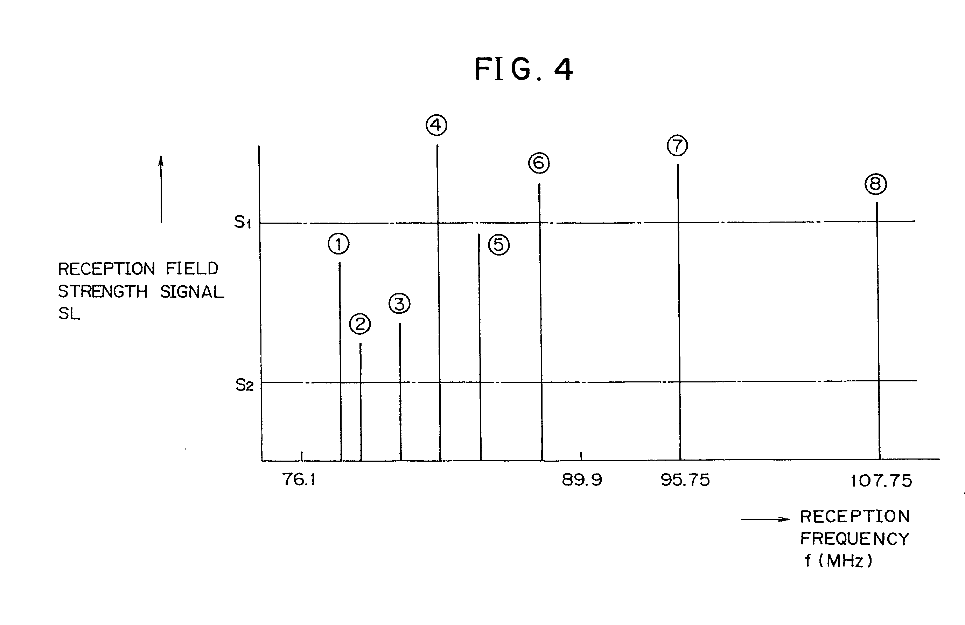

Fig. 4 is an explanatory view showing distribution and reception field strength of a broadcasting station, in which an abscissa axis indicates the reception frequency f, ordinate axis indicates reception field strength signals SL, $S_1$ indicates a first input sensitivity set signals for setting the reception field strength of the front end 2 to a high value, and $S_2$ indicates a second input sensitivity set signal for setting the reception field strength of the front end 2 to a low value.

The reception frequency band includes 76.1 MHz of an FM broadcasting to 107.75 MHz of third channel of a television broadcasting. A main band (dividing frequency band of high seek scanning priority order) includes 76.1 to 89.9 MHz, and a sub band (dividing frequency of low seek scanning priority order) includes 89.9 to 107.75 MHz.

The operation of the arrangement will be described.

When the BSM key of FM in the operating section 7 is first operated to preset broadcasting stations by the BSM function, the control circuit 9 outputs the input sensitivity set signal $S_1$ for setting the reception field strength to a high value to the front end 2, sends frequency dividing data D for setting the reception frequency to 76.1 MHz to the PLL control circuit 3, and stores the value n to "0" in response to the start of the seek-scanning in the memory 6 (step ST1).

Therefore, the PLL control circuit 3 outputs the tuning voltage V based on the frequency dividing data D to the front end 2 to set the reception frequency f to 76.1 MHz. The front end 2 receives the radio wave of 76.1 MHz and sends the reception frequency f to the PLL control circuit 3. Accordingly, the PLL control circuit 3 outputs a lock completion signal L to the control circuit 9.

At this time, if the reception field strength of the front end 2 is higher than the first input sensitivity set signal $S_1$, the front end 2 outputs the reception frequency f to the detecting and demodulating circuit 4. Thus, the detecting and demodulating circuit 4 outputs a station detection signal SD and a reception field strength signal SL based on the reception frequency f.

Then, the control circuit 9 waits for the supply of the lock completion signal L from the PLL control circuit 3, determines whether or not there is a broadcasting station based on the station detection signal SD from the detecting and demodulating circuit 4 (step ST3) when the lock completion signal L is supplied (step ST2), selects six broadcasting stations in the descending order of the stations having larger reception field strength (signals fed through the A/D converter 5), and stores them corresponding to the channels 1 to 6 in the memory 6 (step ST4).

Since the method of selecting the six broadcasting stations in the descending order of the stations having larger reception field strength are known, a detailed description thereof will be omitted.

After the step ST4, or if there is no broadcasting station by the determination in the step ST3, whether or not the reception frequency f is 89.9 MHz is determined (step ST5), the frequency dividing data D for raising the reception frequency f is sent to the PLL control circuit 3 if the reception frequency f is not 89.9 MHz (step ST6), and the program proceeds to the step ST2.

If the reception frequency f is 89.9 MHz in the determination of the step ST5, a value n is increased by one, stored in the memory 6 (step ST7), whether or not all the (six) channels are filled is determined based on the data of the memory 6 (step ST8), and whether or not the value n is "1" is determined if all the channels are not filled yet (step ST9).

If the value n is "1" in the determination of the step ST9, the second input sensitivity set signal $S_2$ for setting the reception field strength to a low value is output to the front end 2, the frequency dividing data D for setting the reception frequency to 76.1 MHz is sent to the PLL control circuit 3 (step ST10), and the program proceeds to the step ST2.

If the value n is not "1" in the determination of the step ST9, a value C is set to "1" corresponding to the first channel of the television broadcasting, stored in the memory 6 (step ST11), the frequency dividing data D for setting the reception frequency to the C channel of the television broadcasting is sent to the PLL control circuit 3 (step ST12), the supply of the lock completion signal L from the PLL control circuit 3 is waited, whether or not there is a broadcasting station is determined based on the station detection signal SD from the detecting and demodulating circuit 4 (step ST14) if the lock completion signal L is supplied (step ST13), and, if there is the broadcasting station, it is preset in next vacant channel stored in the step ST4 (step ST15).

Whether or not the channels are all filled is determined based on the data of the memory 6 (step ST16), and if all the channels are not yet filled, whether or not the value C is 3 is determined (step ST17).

Then, if the value C is not 3 in the determination of the step ST17, the value C is increased by "1", stored in the memory 6 (step ST18), and then the program proceeds to step ST12.

If all the channels are filled in the determination of the steps ST8 and ST16, or if the value C is 3 in the determination of the step ST17, the seek-scanning is finished, and the program proceeds to a reception routine.

When the seek-scanning is carried out as described above, as indicated in the left side of Fig. 3, the frequency band between 76.1 and 89.9 MHz are seek-scanned by the first input sensitivity set signal $S_1$ (high reception field strength seek-scanning) in the steps ST1 to ST6, and then, as indicated in the right side of Fig. 3, the frequency band between 76.1 and 107.75 MHz are seek-scanned by the second input sensitivity set signal $S_2$ (low reception field strength seek-scanning) in the steps ST2 to ST18.

If the reception field strength of the broadcasting stations are distributed as shown in Fig. 4, a broadcasting station (4) can be preset as the channel 1 and a broadcasting station (6) can be preset as the channel 2 in the first seek-scanning. The broadcasting station (4) as the channel 1, the broadcasting station (6) as the channel 2, the broadcasting station (5) as the channel 3, the broadcasting station (1) as the channel 4, the broadcasting station (3) as the channel 5 and the broadcasting station (2) as the channel 6 can be preset in the second seek-scanning. Accordingly, even if the reception field strength of the first channel (7) and the third channel (8) of the television broadcastings are higher than the reception field strength of the broadcasting station (2), they are not preset.

Therefore, the broadcasting stations with the reception field strength higher than predetermined value (second input sensitivity signal $S_2$) in the dividing frequency band having higher seek scanning priority order can be preferentially preset.

If the broadcasting station (3) cannot be, for example, received, the broadcasting station (4) as the channel 1, the broadcasting station (6) as the channel 2, the broadcasting station (5) as the channel 3, the broadcasting station (1) as the channel 4, the broadcasting station (2) as the channel 5 and the first channel (7) of the television broadcasting as the channel 6 can be preset. Thus, the channel numbers can be used as the pointer at the time of tuning the broadcasting station.

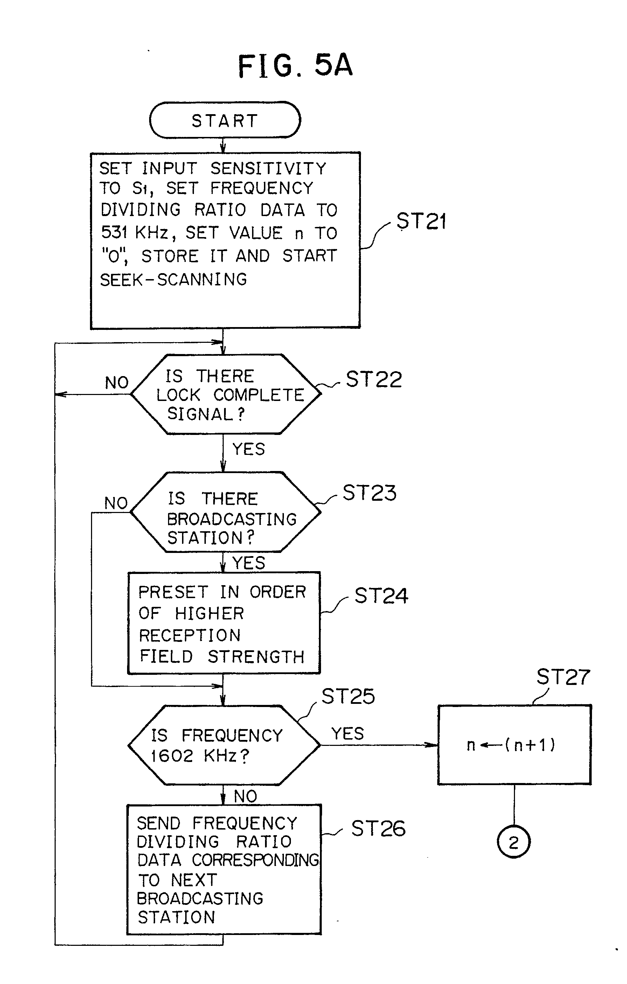

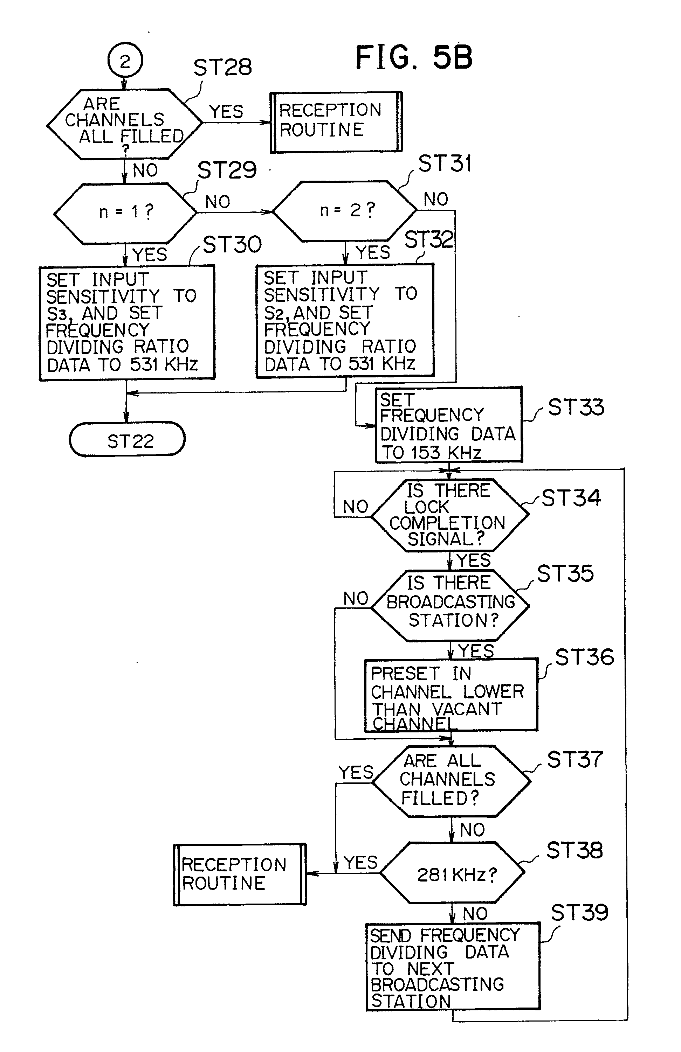

Fig. 5 comprising 5A and 5B is a flow chart for explaining other operation, illustrating steps ST21 to ST39.

The reception frequency band is 153 to 1602 kHz of AM broadcasting, a main band (dividing frequency band of higher seek-scanning priority order) is set to 531 to 1062 kHz, and a sub band (dividing frequency band of lower seek-scanning priority order) is set to 153 to 281 kHz.

In the seek-scanning, an intermediate reception field strength (input sensitivity set signal $S_3$) between the high reception field strength (input sensitivity set signal $S_1$) and the low reception field strength (input sensitivity set signal $S_2$) described above can be set.

The operation of the arrangement constructed as described above will be described.

When the BSM key of the FM in the operation section 7 for presetting the broadcasting station is first operated by the BSM function, the control circuit 9 outputs the first input sensitivity set signal $S_1$ for setting the reception field strength to a high value to the front end 2, sends the frequency dividing data D for setting the reception frequency to 531 kHz to the PLL control circuit 3, and stores the value n corresponding to the start of the seek-scanning in the memory 6 (step ST21).

Then, the supply of the lock completion signal L from the PLL control circuit 3 is waited. When the lock completion signal L is supplied (step ST22), whether or not there is a broadcasting station is determined based on the station detection signal SD from the detecting and demodulating circuit 4 (step ST23), and if there is the station, the six broadcasting stations are selected in the descending order of the stations having larger reception field strength (the signals fed through the A/D converter 5), and stored corresponding to the channels 1 to 6 in the memory 6 (step ST24).

After the step ST24, or if there is not station n the determination of the step ST23, whether or not the reception frequency f is 1062 kHz is determined (step ST25), and if the reception frequency f is not 1602 kHz, the frequency dividing data D for raising the reception signal f is sent to the PLL control circuit 3 (step ST26), and the program proceeds to step ST22.

Further, if the reception frequency f is 1602 kHz in the determination of the step ST25, the value n is increased by "1", and stored in the memory 6 (step ST27). Whether or not all the channels are filled is determined based on the data of the memory 6 (step ST28), and if all the channels are not filled, whether or not the value n is "1" is determined (step ST29).

If the value n is "1" in the determination of the step ST29, a third input sensitivity set signal $S_3$ for setting the reception field strength to the intermediate reception field strength is output to the front end 2, the frequency dividing data D for setting the reception frequency to 531 kHz is sent to the PLL control circuit 3 (step ST30), and the program proceeds to step ST22.

If the value n is not "1" in the determination of the step ST29, whether or not the value n is "2" is determined (step ST31). If the value n is "2", the second input sensitivity set signal $S_2$ for setting the reception field strength to a low value is output to the front end 2, the frequency dividing data D for setting the reception frequency to 531 kHz is sent to the PLL control circuit 3 (step ST32), and the program proceeds to step ST22.

Moreover, if the value n is not "2" in the determination of the step ST31, the frequency dividing data D for setting the reception frequency to 153 kHz is sent to the PLL control circuit 3 (step ST33). Then, the supply of the lock completion signal L from the PLL control circuit 3 is waited, and if the lock completion signal L is supplied (step ST34), whether or not there is a broadcasting station is determined based on the station detection signal SD from the detecting and demodulating circuit 4 (step ST35). If there is a broadcasting station, it is preset in next vacant channel stored in the step ST24 (step ST36).

Whether or not the channels are all filled is determined based on the data of the memory 6 (step ST37), and if all the channels are not yet filled, whether or not the reception frequency f is 281 kHz is determined (step ST38). If the reception frequency f is not 281 kHz, the frequency dividing data D for raising the reception frequency f is sent to the PLL control circuit 3 (step ST39), and the program proceeds to step ST34.

If all the channels are filled in the determinations of the steps ST28, ST37, or if the reception frequency f is 281 kHz in the determination of the step ST38, the seek scanning is finished, and the program proceeds to a reception routine.

Therefore, according to the embodiment (the embodiment based on the flow chart of Fig. 5), the similar effects as those of the previous embodiment are obtained.

Since the seek-scanning is performed with the intermediate reception field strength, if there are a number of stations having the reception field strength higher than predetermined value in the dividing frequency band, a process time for comparing the reception field strength is shortened to accelerate the operation time for presetting the broadcasting stations.

In the embodiments described above, the examples in which the reception field strength are varied in a plurality of stages has been described, however, the seek-scanning may be performed from the dividing frequency band having higher seek-scanning priority order with the same reception field strength.

In the embodiments described above, the example of two seek scanning priority order has been described, however, three or more seek scanning priority order may be provided by preparing the same number of dividing frequency band.

Further, the example in which the dividing frequency band is fixed has been described, however, it is also performed that the dividing frequency bands may be arbitrarily set in the operation section 7. In this case, the desired broadcasting station may be suitably selected.

The example in which the broadcasting stations having the same dividing frequency band are stored in the descending order of high electric field intensity in accordance with channels in the descending order. However, they may also be stored in the frequency order.

The example in which the lowest dividing frequency band of the seek-scanning priority order is seek-scanned with the low reception field strength has been described. However, the dividing frequency band may be seek-scanned with the high or intermediate reception field strength.

According to the present invention as described above, the radio station presetting method has the steps of dividing the frequency band into a plurality of dividing frequency bands with a seek-scanning priority order, seek-scanning the dividing frequency band having highest seek-scanning priority order to determine whether or not the number of broadcasting stations with the reception field strength higher than a specified level becomes the predetermined number, retaining, when the number is less than the predetermined number, the broadcasting stations which are preset with the dividing frequency band having the highest seek scanning priority order as they are, or the seek-scanning includes a high reception field strength seek-scanning for presetting broadcasting stations with the reception field strength higher than a predetermined level and a low reception field strength seek-scanning for presetting broadcasting stations having lower reception field strength by a predetermined level than the predetermined level applied to the high field strength seek-scanning. Therefore, if there is broadcasting stations with the reception field strength higher than a predetermined level (or a lower level), they are preset in the descending order of the dividing frequency band of higher seek-scanning priority order.

At least one intermediate reception field strength seek-scanning is set between a high reception field strength seek-scanning for presetting broadcasting stations with the reception field strength higher than a predetermined level and a low reception field strength seek-scanning for presetting broadcasting stations having lower reception field strength by a predetermined level than the predetermined reception field strength applied to the higher reception field strength seek-scanning, and seek-scanning from said high reception field strength seek-scanning side. Therefore, if there are a number of broadcasting stations having reception field strength higher than a predetermined (low) level in the dividing frequency band, the process time for comparing the reception field strength is shortened, thereby accelerating the operation time of presetting the stations.

Further, broadcasting stations to be preset in the descending order of the dividing frequency band having higher seek-scanning priority order are allocated to channels in the descending order. Therefore, the number of the channels can be used as a pointer at the time of tuning the station.

A plurality of dividing frequency bands can be arbitrarily set. Therefore, the desired broadcasting station can be suitably selected.

**Claims**

1. In a radio station presetting method for radio receivers, in which seek-scanning is performed over a frequency band of the same modulation type to select a predetermined number of station with the reception field strength higher than a specified level in the descending order of reception field strength, said method comprising the steps of:

dividing said frequency band into a plurality of dividing frequency bands with a seek-scanning priority order;

seek-scanning the dividing frequency band having highest seek-scanning priority order to determine whether or not the number of broadcasting stations with the reception field strength higher than the specified level becomes said predetermined number;

retaining the broadcasting stations which are preset with the dividing frequency band having the highest seek-scanning priority order as they are when the number of said broadcasting stations is less than said predetermined number;

seek-scanning the dividing frequency band having next higher seek-scanning order to determine whether or not the number of broadcasting stations with the reception field strength higher than the specified level becomes said predetermined number;

retaining the broadcasting stations which are so far as they are when the number of said broadcasting stations is less than said predetermined number; and

sequentially repeating said operation for said dividing frequency band of lower seek-scanning priority order.

2. A radio station presetting method as claimed in claim 1, wherein said seek-scanning includes a high reception field strength seek-scanning for presetting broadcasting stations with the reception field strength higher than a predetermined level and a low reception field strength seek-scanning for presetting broadcasting stations with the reception field strength higher than a predetermined level which is lower than the predetermined level applied to the high reception field strength seek-scanning by a prescribed level.

3. A radio station presetting method as claimed in claim 2, wherein at least one intermediate reception field strength seek-scanning is set between the high reception field strength seek-scanning for presetting broadcasting stations with the reception field strength higher than a predetermined level and the low reception field strength seek-scanning for presetting broadcasting stations with the reception field strength higher than a predetermined level which is lower than the predetermined level applied to the high reception field strength seek-scanning by a prescribed level, seek-scanning is performed from the high reception field strength seek-scanning side.

4. A radio station presetting method as claimed in claim 1, 2, or 3, wherein broadcasting stations to be preset in the descending order of the dividing frequency band having high seek-scanning priority are allocated to channels in the descending order.

5. A radio station presetting method as claimed in claim 1, 2, 3 or 4, wherein a plurality of said dividing frequency bands are arbitrary set.

# F I G. 1

# FIG. 2A

START

SET INPUT SENSITIVITY
TO S$_1$, SET FREQUENCY
DIVIDING RATIO DATA TO
76.1MHz, SET VALUE n TO
"O", STORE IT AND START
SEEK-SCANNING — ST1

IS THERE LOCK
COMPLETION
SIGNAL ? — ST2
NO
YES

IS THERE
BROADCASTING
STATION ? — ST3
NO
YES

PRESET IN THE
DESCENDING ORDER
OF HIGHER
RECEPTION FIELD
STRENGTH — ST4

IS FREQUENCY
89.9 MHz ? — ST5
YES

n ← (n+1) — ST7

NO

SEND FREQUENCY
DIVIDING RATIO
DATA CORRESPONDING
TO NEXT
BROADCASTING
STATION — ST6

1

9

# FIG. 2B

ST8 — ARE CHANNELS ALL FILLED ? — YES → RECEPTION ROUTINE

NO ↓

ST9 — n = 1 ? — NO → ST11 STORE VALUE C AS "1"

YES ↓

ST10 — SET INPUT SENSITIVITY TO $S_2$, AND SET FREQUENCY DIVIDING RATIO DATA TO 76.1 MHz

ST2

ST12 — SET FREQUENCY DIVIDING DATA TO CHANNEL C

ST13 — IS THERE LOCK COMPLETION SIGNAL? — NO

YES ↓

ST14 — IS THERE BROADCASTING STATION? — NO

YES ↓

ST15 — PRESET IN CHANNEL LOWER THAN VACANT CHANNEL

ST16 — ARE ALL CHANNELS FILLED? — YES → RECEPTION ROUTNE

NO ↓

ST17 — C = 3 ? — YES → RECEPTION ROUTNE

NO ↓

ST18 — C ← (C + 1)

10

# FIG. 3

RECEPTION
FREQUENCY
f (MHz)

107.75

101.75

95.75
89.9

76.1

HIGH RECEPTION FIELD
STRENGTH
SEEK-SCANNIG

LOW RECEPTION FIELD
STRENGTH SEEK-SCANNING

START

END

TIME (t)

EP 0 450 268 A2

# FIG. 4

RECEPTION FIELD
STRENGTH SIGNAL
SL

S₁

S₂

① ② ③ ④ ⑤ ⑥ ⑦ ⑧

76.1    89.9    95.75    107.75

→ RECEPTION
FREQUENCY
f (MHz)

EP 0 450 268 A2

# FIG. 5A

START

SET INPUT SENSITIVITY
TO S₁, SET FREQUENCY
DIVIDING RATIO DATA TO
531 KHz, SET VALUE n TO
"0", STORE IT AND START
SEEK-SCANNING — ST21

IS THERE LOCK COMPLETE SIGNAL? — ST22 — NO

YES

IS THERE BROADCASTING STATION? — ST23 — NO

YES

PRESET IN ORDER OF HIGHER RECEPTION FIELD STRENGTH — ST24

IS FREQUENCY 1602 KHz? — ST25 — YES → n ← (n+1) — ST27 → ②

NO

SEND FREQUENCY DIVIDING RATIO DATA CORRESPONDING TO NEXT BROADCASTING STATION — ST26

# FIG. 5B